## Europäisches Patentamt
## European Patent Office
## Office européen des brevets

(19)

(11) Publication number: **0 253 295**
**A1**

(12)

# EUROPEAN PATENT APPLICATION

(21) Application number: **87109870.3**

(51) Int. Cl.⁴: **H 01 L 23/36, H 01 L 23/30**

(22) Date of filing: **08.07.87**

(30) Priority: **09.07.86 US 883894**

(71) Applicant: **TEKTRONIX, INC., Tektronix Industrial Park D/S Y3-121 4900 S.W. Griffith Drive P.O. Box 500, Beaverton Oregon 97077 (US)**

(72) Inventor: **Timmins, Kelly A., 14625 S.W. 87th, Tigard Oregon 97224 (US)**
Inventor: **Schroeder, Scott L., 14095 S.W. Walker Road No. 130, Beaverton Oregon 97005 (US)**
Inventor: **Bauer, Charles E., Route 1 Box 147, Cornelius Oregon 97113 (US)**

(43) Date of publication of application: **20.01.88 Bulletin 88/3**

(74) Representative: **Strasse, Joachim, Dipl.-Ing. et al, Strasse und Stoffregen European Patent Attorneys Zweibrückenstrasse 17, D-8000 München 2 (DE)**

(84) Designated Contracting States: **DE FR GB NL**

(54) **Thermally enhanced LSI integrated circuit package.**

(57)  A high power plastic LSI integrated circuit package is disclosed having a low resistance thermal path from the integrated circuit die (12) to a metal heat spreader (16) on the top of the package. The thermal path includes a thermally conductive electrical insulator, (14) such as beryllium oxide, sandwiched between the integrated circuit die (12) and the heat spreader (16). The opposing surfaces of the beryllium oxide are metallized and soldered to the die and heat spreader, respectively. Interface between the integrated circuit die (12) and the printed circuit board (30) is effected by a lead frame (32) epoxied to the heat spreader (16) in a manner that avoids contamination of the wire bonding surface. The package provides a junction-to-case thermal resistance of one to two orders of magnitude less than other plastic chip carriers.

# THERMALLY ENHANCED LSI INTEGRATED CIRCUIT PACKAGE

## TECHNICAL FIELD

The present invention relates to LSI and VLSI integrated circuit packages, and more particularly to plastic LSI and VLSI integrated circuit packages capable of dissipating large amounts of heat.

Plastic chip carriers are increasingly being used to package integrated circuits. Their low cost and reliability make them well suited for instrumentation, computer, industrial control, telecommunications, entertainment and certain non-critical military applications. However, plastic encapsulated devices are poorly suited for dissipating more than one watt of heat. As more circuitry is incorporated into integrated circuits, the need for plastic packages capable of dissipating more heat has become critical.

The heat dissipation problems associated with LSI and VLSI devices are particularly acute due to the stringent temperature limits within which these circuits must be operated. While a power transistor substrate can be operated satisfactorily at a temperature of 200°C, the maximum operating temperature of an LSI or VLSI substrate is much lower. The reason for the low limit on operating temperature is the thermal mobility of the impurities used to dope the semiconductor substrate to form the individual LSI or VLSI circuit components. In a power transistor, each doped area is relatively large, so that some thermally induced interdiffusion of impurities into adjacent regions is not critical. However, since the geometric detail used in LSI and VLSI devices is so fine, even a comparatively small amount of impurity interdiffusion into adjacent regions can render an LSI or VLSI device inoperative.

One approach to conducting heat away from an LSI circuit is illustrated by a package marketed by SGS-Ates (Agrate, Italy). In this device, the lead frame which interfaces the integrated circuit to the circuit board is used to conduct heat. A 44-pin version, for example, dedicates 33 leads to signals and the other 11 (along one side) to conducting heat into the printed circuit board. One end of each of the 11 leads is soldered to the board, while the other end is glued to the die bottom. The junction-to-case thermal resistance claimed by SGS-Ates is on the order of 12°C per watt, as compared with figures of between 20°C to 100°C per watt for conventional plastic packages.

Other approaches to the heat dissipation problem are illustrated by techniques used in the construction of power transistors and small scale integrated circuit devices. Power transistors are often constructed in metal cases that serve as heat spreaders or as conduits to a heat sink. In such construction, the metal case is soldered directly to the semiconductor substrate, thereby reducing the thermal resistance between the substrate and ambient and simultaneously making the metal case an electrical terminal of the transistor device.

Such construction is ill-suited for adaptation to LSI and VLSI integrated circuits. The substrates on which LSI and VLSI circuits are fabricated sometimes need to be electrically isolated from the device enclosure. Although a metal enclosure can be electrically isolated from other circuit elements (as by the mica insulating washers and non-conductive hardware used in some power transistor applications), such approach provides unsatisfactorily high thermal resistances for most LSI and VLSI circuit devices.

Similarly, some small scale integrated circuit packages conduct heat away from the substrate by a thermally conductive epoxy resin which transfers heat to the outside of the package. However, the thermal resistance associated with such epoxy bonded packaging techniques is again too high for use in demanding LSI and VLSI applications.

In addition to the lowered operating temperature required by LSI and VLSI circuits to minimize thermal impurity interdiffusion, it is also desirable to reduce operating temperature to prolong circuit lifetimes. Studies indicate that the operating lifetime of an integrated circuit can be approximately doubled for every 10°C reduction in operating temperature within the 140°C to 180°C range. Accordingly, it is highly desirable to reduce the temperatures at which integrated circuits operate. However, reducing the temperatures at which integrated circuits operate also reduces the temperature budget within which heat can be dissipated. Most current LSI and VLSI integrated circuit heat dissipating technology is designed to operate within a temperature budget of a 55°C temperature rise (125°C maximum junction operating temperature minus 70°C worst case ambient instrument temperature). To operate an integrated circuit within a smaller temperature budget further exacerbates the heat dissipation problems associated with LSI and VLSI integrated circuits.

Accordingly, a need exists for a thermally enchanced LSI and VLSI integrated circuit package.

## SUMMARY OF THE INVENTION

One object of the present invention is to provide a high power LSI integrated circuit package.

Another object of the present invention is to provide a high power LSI integrated circuit package having dimensions and pinout which conform to JEDEC Plastic Chip Carrier Family Standard MO-047 (October 31, 1984).

Still another object of the present invention is to provide an LSI integrated circuit package having an extremely low junction-to-case thermal resistance.

Yet another object of the present invention is to eliminate epoxy interfaces in the route of direct heat transfer from junction to ambient in an LSI integrated circuit package.

The present invention is a high power plastic LSI integrated circuit package that includes a low thermal resistance path from the integrated circuit die to a metal heat spreader on the top of the package. The thermal path includes a thermally conductive electrical insulator, such as beryllium oxide or aluminum nitride, sandwiched between the integrated circuit die and the heat spreader. The opposing surfaces of the thermally conductive electrical insulator are metallized and metallurgically bonded to the die and heat spreader, respectively. Electrical interface between the integrated circuit die and the printed circuit board is effected by a lead frame epoxied to the heat spreader in a manner that avoids contamination of the wire bonding surface. The package can provide a junction-to-case thermal resistance on the order of 1°C/W.

The foregoing and additional objects, features and advantages of the present invention will be more readily apparent from the following detailed description of a preferred embodiment thereof, which proceeds with reference to the accompanying drawings.

## BRIEF DESCRIPTION OF THE DRAWINGS

Fig. 1 is a cross-sectional view showing an integrated circuit die mounted in an integrated circuit package according to the present invention.

Fig. 2 is an enlarged detail of the view of Fig. 1 showing the elements of the thermal conduction assembly.

Fig. 3 is a detail of a plan view of the integrated circuit package of Fig. 1 showing the integrated circuit die and its attachments to the lead frame prior to encapsulation.

## DETAILED DESCRIPTION OF A PREFERRED EMBODIMENT

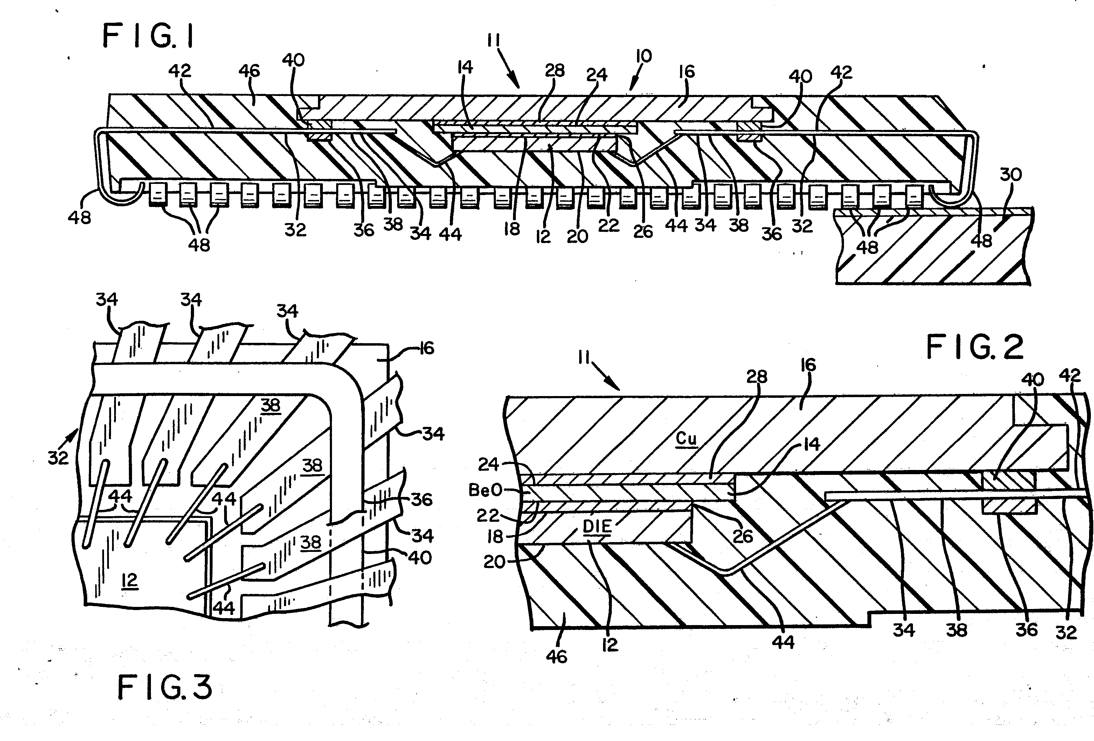

With reference to Figs. 1-3, the integrated circuit package 10 of the present invention includes an integrated circuit die 12, a thermally conductive electrical insulator 14 and a metal heat spreader 16. The thermally conductive electrical insulator 14 can be of a material such as beryllium oxide, diamond, silicon carbide, aluminum nitride or any other electrical insulator having comparable thermal conductivities. For convenience of reference, a preferred embodiment using beryllium oxide is illustrated.

Integrated circuit die 12 has a planar surface 18 and a second surface 20 to which connections are made. Thermally conductive electrical insulator 14 has first and second opposed surfaces 22, 24, both of which are metallized with layers of molybdenum-manganese, nickel and a final layer of gold. A first metal bonding material 26, such as a solder, is used to unite planar surface 18 of die 12 to the metallization on first surface 22 of thermally conductive electrical insulator 14. A second metal bonding material 28 is used to unite the metallization on second surface 24 of thermally conductive electrical insulator 14 to the metal heat spreader 16. In the preferred embodiment, metal heat spreader 16 is formed of Olin 151 copper having surface dimensions of one inch square, base dimensions of 1.062 inches square and a height of 0.05 inches. First metal bonding material 26, beryllium oxide chip 14, second metal bonding material 28 and metal heat spreader 16 together comprise a thermal conductor assembly 11 which conducts heat from integrated circuit die 12 to ambient.

The interface between integrated circuit die 12 and a circuit board 30 is provided by a lead frame 32. Lead frame 32 comprises a plurality of fingers 34 extending inwardly toward integrated circuit die 12. Unlike conventional integrated circuit lead frames, the lead frame 32 used in the present invention does not have a die attachment pad. Instead, the die is inverted compared to standard packaging styles and is secured to the beryllium oxide substrate 14.

In the preferred embodiment, lead frame 32 has a lead tip width of approximately 6 mils and a lead spacing of 5 mils. The lead frame is made of Olin 151 copper, plated with 50 millionths of an inch nickel and further plated at the tips with 50 millionths of an inch gold.

A polyimide tape 36 extends around the lead frame 32, on a first surface 38 of each lead finger, to lend structural support to the delicate lead frame during manufacturing. The width of tape 36 is on the order of 80 mils. An epoxy preform 40, or other electrically insulating bonding material, also extends around the lead frame on a second surface 42 of each lead frame finger 34 to bond the lead frame to and spaced apart from the metal heat spreader 16. This epoxy bond holds lead frame 32 fixed relative to die 12 and thermal conduction assembly 11 so that wires from the die can be attached to the lead frame fingers. In the preferred embodiment, epoxy preform 40 is cut from a 5 mil thick sheet of Ablefilm 550k (Ablestik Laboratories, Gardena, California) and has a width of approximately 80 mils.

Interconnection between integrated circuit die 12 and lead frame 32 is provided by a plurality of gold wires 44. Wires 44 connect circuit elements on the second surface 20 of die 12 with the first surface 38 of lead fingers 34. The diameter of wires 44 is approximately 1.3 mils. Contamination of the wire bonding surfaces of lead fingers 34 is prevented by positioning epoxy 40 on the second side 42 of lead finger 34, spaced well away from the bonding surfaces. Any epoxy that creeps from second surface 42 to first surface 38 during the curing process is spaced sufficiently from the wire bonding surface to render contamination unlikely. Contamination can be further avoided by positioning polyimide tape 36 inwardly of epoxy 40 on lead frame 32 to act as a dam against epoxy creeping on the first side 38 of lead frame 32 toward the wire bonding surface.

A plastic package 46 encapsulates the assembly, with heat spreader 16 exposed at the top surface to conduct heat from integrated circuit die 12 to the ambient air. Plastic package 46 can be formed of MG 25F molding compound (Hysol Division, The Dexter Corp., Pittsburg, PA). Heat spreader 16 is notched around its upper edges, as shown in Figs. 1 and 3, so that the encapsulating plastic will hold it securely in place. Pins 48 for interconnection between lead frame 32 and printed circuit board 30 also extend out from the encapsulated package.

It is desirable that the solders bonding the beryllium oxide metallization to the die and to the copper heat spreader have different melting temperatures for ease of fabrication. In the preferred embodiment, the brazing compound used to bond the beryllium oxide metallization to the copper is a preform comprised of 80% silver and 20% copper having a melting temperature of about 800°C. The compound used to bond the beryllium oxide metallization to the integrated circuit die is a preform comprised of gold and silicon having a melting temperature of approximately 380°C. Both preforms are generally about one-half mil thick.

Fabrication of one integrated circuit package according to the present invention proceeds as follows: Second metallized surface 24 of beryllium oxide chip 14 is soldered to heat spreader 16 using the higher temperature solder 28. Thereafter, planar surface 18 of die 12 is soldered to first metallized surface 22 of beryllium oxide chip 14 using the lower temperature solder 26. Fabrication in this sequence allows the second solder bond to be made without disrupting the higher temperature, first solder junction.

The lead frame 32, including polyimide tape 36, is next bonded to the heat spreader 16 by the epoxy preform 40. Epoxy preform 40 is supplied in the B stage (partially crosslinked) and is cured at 150°C for thirty minutes to complete the bonding process.

After lead frame 32 is bonded to heat spreader 16, the wires 44 interconnecting die 12 to lead frame 32 are added. The wire connections can be dressed with a junction coating compound, such as Dow Corning 6103 (not illustrated). The completed unit is encapsulated in plastic molding compound 46 using a book mold and a twenty ton press. The protruding lead frame fingers are then formed into the desired J lead shape. J leads 48 are oriented so as to position package 10, when mounted to circuit board 30, with the surface containing heat spreader 16 up, away from the circuit board and exposed to ambient air.

The junction-to-case thermal resistance of integrated circuit packages according to the present invention is typically between one and two orders of magnitude less than that of competing technologies. The theoretical components of this thermal resistance, as determined by conventional procedures, break down approximately as follows:

| Junction to first solder | .125°C/W |
| First solder to BeO | .001°C/W |
| BeO to second solder | .051°C/W |
| Second solder to heat spreader | .001°C/W |
| Bottom of heat spreader to top | .1°C/W |

Actual thermal resistances on the order of 1°C/W can be achieved in practice. (This compares with the approximately 12°C/W figure claimed for the above referenced SGS-Ates device.)

The above theoretical figures are based on a die size of 48,216 square mils; a first metallurgical bonding material comprised of 96.9% gold, 3.1% silicon; a beryllium oxide substrate measuring 0.25 inches square by 0.01 inches thick; a second alloy comprised of 82% gold, 18% indium; and a copper heat spreader having a thickness of .050 inch and an upper surface area of one square inch.

The present invention achieves its high thermal conductivity by avoiding the use of any bonding resin in the path of direct heat transfer from junction to ambient. All connections are made instead by metallurgical bonding materials. If the same assembly were fabricated with epoxy bonds, the thermal resistance would increase by more than an order of magnitude.

Thermal performance of the present invention is further enhanced by inverting the die relative to its position in conventional packages. The orientation of the die with its planar base surface up allows the die to be bonded to a low thermal resistance path that transfers heat to the top of the package and to the ambient air. Other competing technologies, such as the referenced SGS-Ates device, rely solely on thermal conduction along a high thermal resistance path to remove heat.

While the above discussion has been made with reference to a single preferred embodiment, it will be apparent to those skilled in the art that the invention can be modified in arrangement and detail without departing from its basic principles. For example, the package's J leads can be oriented in the opposite direction so that the heat spreader is on the undersurface of the package, adjacent the circuit board. In such embodiment, a direct thermal connection can be made between the heat spreader and the circuit board, either by extending the heat spreader beyond the surface of the encapsulating material to the board, or by providing an intermediate thermal conductor between these elements. Similarly, in another modified embodiment, the illustrated lead frame can be replaced by a tape automated bonding system, thereby simplifying device fabrication and increasing packing density.

Embodiments incorporating these and many other variations can all be made using the basic principles of the present invention. Accordingly, we claim as our invention all such modifications that come within the scope and spirit of the following claims.

1. A package for an integrated circuit die comprising:
a thermal conduction assembly;
containment means for containing the integrated circuit die and the thermal conduction assembly, said containment means having first and second opposed surfaces and being adapted for mounting on a circuit board with the first surface positioned adjacent the circuit board and with the second surface spaced away from the circuit board, one of said surfaces including heat spreader means for dissipating heat;
the thermal conduction assembly including:
a thermally conductive electrical insulator having first and second opposed metallized surfaces;
first metal bonding means for bonding the integrated circuit die to the first metallized surface of the electrical insulator; and
second metal bonding means for bonding the second metallized surface of the electric insulator to the heat spreader means.

2. The package of Claim 1 in which the second surface included the heat spreader means.

3. The package of Claim 1 which further comprises:
lead frame means including a plurality of centrally extending electrically conductive fingers, each having first and second opposed surfaces, for making electrical connections to die;
insulated bonding means for bonding the second surface of the lead frame fingers to an spaced apart from the heat spreader means; and
wire means for connecting the first surface of the lead frame fingers to the integrated circuit die.

4. An integrated circuit device comprising:
an integrated circuit die having first and second opposed surfaces;

connection means for making electrical connections to the second surface of the die;

heat spreader means for dissipating heat;

insulted bonding means for bonding the connection means to and spaced apart from the heat spreader means;

a thermally conductive electrical insulator;

bonding means for bonding the thermally conductive electrical insulator between the first surface of the integrated circuit die and the heat spreader means; and

containment means having first and second opposed surfaces for containing said die, connection means, heat spreader means, insulated bonding means, insulator and bonding means, the heat spreader means extending through said containment means to one of said containment surfaces.

5. A method of mounting an integrated circuit die comprising the steps:

providing a metal member;

providing a thermally conductive electrical insulator having first and second opposite planar sides;

metallizing the first and second opposed planar sides of the electrical insulator;

soldering the first metallized side of the electrical insulator to the die;

soldering the second metallized side of the electrical insulator to the metal member; and

encapsulating the die, the thermally conductive electrical insulator and a portion of the metal member in an electrically insulating material such that heat from the integrated circuit can be conducted to an outer surface of the encapsulating electrically insulating material.

6.   The method of claim 4 which further comprises the steps:

providing a lead frame having first and second sides and having centrally extending fingers;

connecting wires between the integrated circuit die and the first sides of the lead frame fingers; and

bonding the second side of the lead frame to and spaced apart from the metal member.

FIG.1

FIG.2

FIG.3

0 253 295

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| Y | PATENT ABSTRACTS OF JAPAN, vol. 9, no. 263 (E-351)[1986], 19th October 1985; & JP-A-60 110 146 (MATSUSHITA DENSHI KOGYO K.K.) 15-06-1985 * Abstract * | 1,3-6 | H 01 L 23/36 H 01 L 23/30 |
| Y | DE-A-3 145 648 (HITACHI) * Figure 3; page 20, lines 4-26 * | 1,3-6 | |
| A | PATENT ABSTRACTS OF JAPAN, vol. 10, no. 1 (E-371)[2058], 7th January 1986; & JP-A-60 165 745 (TOSHIBA K.K.) 28-08-1985 * Abstract * | 1,2,4-6 | |
| A | PATENT ABSTRACTS OF JAPAN, vol. 9, no. 69 (E-305)[1792], 29th March 1985; & JP-A-59 207 645 (TOSHIBA K.K.) 24-11-1984 * Abstract * | 1,2,4-6 | **TECHNICAL FIELDS SEARCHED (Int. Cl.4)**<br><br>H 01 L |
| A | EP-A-0 047 195 (EFCIS) * Figure 3; page 4, line 2 - page 5, line 2 * | 1,3-6 | |
| A | EP-A-0 052 054 (FAIRCHILD) | | |
| A | EP-A-0 139 205 (SIEMENS) | | |

The present search report has been drawn up for all claims

| Place of search | Date of completion of the search | Examiner |
|---|---|---|
| THE HAGUE | 06-10-1987 | CAMPLING N.C.G. |